**Europäisches Patentamt**

**European Patent Office**

**Office européen des brevets**

(19)

(11) **EP 1 376 881 A1**

(12) **EUROPÄISCHE PATENTANMELDUNG**

(43) Veröffentlichungstag:
**02.01.2004  Patentblatt 2004/01**

(51) Int Cl.[7]: **H03M 13/41**, H03M 13/45,
H04L 1/00, H04L 25/03

(21) Anmeldenummer: **02014456.4**

(22) Anmeldetag: **28.06.2002**

(84) Benannte Vertragsstaaten:
**AT BE CH CY DE DK ES FI FR GB GR IE IT LI LU
MC NL PT SE TR**
Benannte Erstreckungsstaaten:
**AL LT LV MK RO SI**

(71) Anmelder: **SIEMENS AKTIENGESELLSCHAFT
80333 München (DE)**

(72) Erfinder:
- **Bossert, Martin, Prof.
  Ulm 89075 (DE)**
- **Freudenberger, Jügen
  Ulm 89075 (DE)**
- **Stender, Boris
  Buxheim (DE)**

(54) **Verfahren zur Kanaldecodierung**

(57)    Die Erfindung betrifft ein Verfahren zur Berechnung von Zuverlässigkeitswerten (Zuverl.) von mindestens einem Kanaldecodierergebnis, welches in Form einer am wahrscheinlichsten gesendeten Codesymbolfolge ermittelt wird, bei der empfängerseitigen Decodierung in einem digitalen Kommunikationssystem, in welchem faltungscodierte Informationen übertragen werden. Erfindungsgemäß erfolgt die Berechnung der Zuverlässigkeitswerte (Zuverl.) zumindest teilweise segmentweise.

Ein Vorteil des erfindungsgemäßen Verfahrens besteht darin, dass, da die Fehler bei Verwendung von Faltungscodes in bestimmten Segmenten gehäuft auftreten, eine Lokalisierung und Zuverlässigkeitsquantifizierung dieser fehlerhaften Segmente aufgrund der segmentweisen Berechnung ermöglicht wird.

EP 1 376 881 A1

**Beschreibung**

Die Erfindung betrifft ein Verfahren zur Berechnung von Zuverlässigkeitswerten von mindestens einem Kanaldecodierergebnis in Form einer am wahrscheinlichsten gesendeten Codesymbolfolge bei der empfängerseitigen Decodierung in einem digitalen Kommunikationssystem, in welchem faltungscodierte Informationen übertragen werden.

Ein wie auch immer geartetes Kommunikationssystem zerfällt in der Regel in ein Anwendungssystem und ein Transportsystem. Das Transportsystem stellt dabei einen sicheren, d.h. fehlerfreien und qualitativ hochwertigen, Transportweg zwischen Teilnehmern zur Verfügung. Das Anwendungssystem setzt diesen Transport voraus und interpretiert die transportierten Daten (Sprache, Bilder, Daten, etc.) auf eine bestimmte Art und Weise, um sie dem Teilnehmer entsprechend nutzbar zu machen. Das Transportsystem kann grundsätzlich eine verbindungslose Datenübertragung oder eine verbindungsorientierte Datenübertragung unterstützen.

Nachrichtenkanäle, insbesondere Funkkanäle, sind einer Vielzahl von Störungen ausgesetzt. Unvermeidbar bei allen Systemen ist die Störung durch das Rauschen der Empfänger. Dies ist meist additives weißes Gaußsches Rauschen. Die Bewertung und Auslegung von Übertragungsverfahren erfolgt häufig lediglich aufgrund dieser Störeinflüsse, d.h. das System wird am klassischen Kanal mit Gaußschem weißem Rauschen analysiert. Tatsächlich aber zeigen z.B. Mobilfunkkanäle viele zusätzliche Störungen, hervorgerufen durch Mehrwegeempfang, Streuung, Fading, Totalausfälle, Impulsstörungen, Interferenz von anderen Teilnehmern und Störsignalen.

Bei der digitalen Übertragung von Information über einen Kanal werden üblicherweise Verfahren der Kanalcodierung eingesetzt, um eine zuverlässige, d.h. weitesgehendst fehlerfreie, Datenübertragung zu gewährleisten. Insbesondere in Systemen zur mobilen Kommunikation sind Verfahren zur Fehlerkorrektur ein wesentlicher Bestandteil der Übertragungstechnik.

Bei dem Begriff Kanalcodierung handelt es sich um einen Oberbegriff für alle Codierverfahren, bei welchen die Eigenschaft eines Übertragungskanals berücksichtigt wird, um die Redundanz von zu übertragenden Daten gezielt zur Fehlererkennung und Fehlerkorrektur zu erhöhen. Im Gegensatz hierzu reduziert die Quellencodierung die Redundanz. Möglichkeiten zur Kanalcodierung sind z.B. die Blockkodierung und die Faltungscodierung.

Bei der Faltungscodierung handelt es sich um eine Abbildung von a eingehenden Informationsbits auf b ausgehende, kanalcodierte Bits, d.h. je eingehende a Bits werden b Bits ausgegeben. Das Verhältnis a/b wird als Code-Rate bezeichnet. Die Vorschrift, nach der aus den a Bits innerhalb des Codierers die b ausgehenden Bits erzeugt werden, wird durch die sogenannte Einflussrate L+1 beeinflusst, da die b Ausgangsbits durch insgesamt (L+1)*a zwischengespeicherte Eingangsbits beeinflusst werden. Technisch wird ein Faltungscodierer durch eine digitale Schaltung aus L Schieberegistern realisiert, deren Inhalte auf b verschiedene Arten zusammen mit dem aktuell eingehenden Datenbit durch Addition und Modulo-2-Operationen verknüpft werden.

Im Encoder findet beim Sender die Umwandlung eines Informationswortes in ein Codewort (eine Codesymbolfolge) statt, welches dann über den Übertragungskanal zum Empfänger gesendet wird. Während der Übertragung wird das Codewort durch Störeinflüsse verfälscht. Die Aufgabe des Decoders auf der Empfängerseite besteht nun darin, aus dem empfangenen, verfälschten Signal das gesendete Codewort (die Codesymbolfolge) zu ermitteln. Das ermittelte Codewort stellt dann das Kanaldecodierergebnis dar. Dies kann aufgrund der Störeinflüsse nicht mit 100%-iger Sicherheit bestimmt werden, daher wird im allgemeinen das am wahrscheinlichsten gesendete Codewort ermittelt. Dieses kann dann anhand von Rechenvorschriften in das Informationswort umgewandelt werden.

Codeworte können effektiv mittels eines Trellis-Diagramms dargestellt werden. Bei einem Trellis-Diagramm handelt es sich um ein Netzdiagramm bzw. einen gerichteten Graphen. Es stellt eine optimierte Darstellung eines Entscheidungsbaums dar. Das Trellis repräsentiert alle Codeworte, die gesendet werden können. Ein Trellis weist eine Menge von Knoten und eine Menge von Zweigen auf. Die Menge der Knoten kann in Untermengen verschiedener Tiefen t aufgeteilt werden. Ein Zweig führt von einem Knoten der Tiefe t zu einem Knoten der Tiefe t+1. Im speziellen beinhalten die Knotenmengen der Tiefe t=0 und t=n jeweils nur einen Knoten. Das bedeutet, der Knoten bei t=0 ist der Anfangsknoten eines Trellisses und der Knoten bei t=n ist der Endknoten desselben. Ein Pfad im Trellis ist eine Folge von Zweigen, der von einem Knoten zu einem anderen Knoten führt. Jeder Zweig kann mit einem Symbol nummeriert werden. Jeder Pfad entspricht einem Vektor, der aus den Symbolen der jeweiligen Zweige zusammengesetzt wird.

Ein Trellis wird Codetrellis genannt, wenn für jeden Pfad zwischen zwei Knoten der durch den Pfad gebildete Vektor zum betrachteten Code gehört, und wenn für jedes Codewort mindestens ein Pfad zwischen zwei Knoten des Trellisses existiert, so dass der durch den Pfad gebildete Vektor dem Codewort entspricht.

Ein oftmals eingesetztes Decodierverfahren ist der Viterbi-Algorithmus. Hierbei wird durch das Verwerfen von Alternativen das am wahrscheinlichsten gesendete Codewort durch das Trellis ermittelt. Dieses Ergebnis, d.h. der beste Pfad durch das Trellis, wird aufgrund des Verfahrens »Survivor" (vom englischen: Überlebender) genannt.

Aufgrund der Struktur der verwendeten Faltungscodes treten nach dem Decodieren, d.h. innerhalb des Kanaldecodierergebnisses, typischerweise Fehlermuster auf, bei denen sich fehlerfreie Segmente und Segmente mit gehäuften Fehlern, d.h. stark fehlerbehaftete Segmente, aneinander reihen.

Unter einem Segment werden hier mehrere, direkt aufeinander folgende Symbole verstanden. In einem Trellis-Diagramm entspricht einem Symbol ein Trellisübergang, d.h. der Übergang von einem Knoten der Tiefe t zu einem Knoten der Tiefe t+1 oder t-1.

Augrund der nach dem Decodieren immer noch vorhandenen Fehler ist es wünschenswert, neben dem Ergebnis der Kanaldecodierung, d.h. dem am wahrscheinlichsten gesendeten Codewort, Informationen über die Zuverlässigkeit dieses ermittelten Codewortes zu erhalten.

Bisherige Algorithmen berechnen Zuverlässigkeitswerte von Kanalcodierergebnissen entweder für gesamte Codeworte oder nur für jeweils ein Symbol. Hierfür seien folgende Algorithmen genannt:

■ Der ROVA (Raghavan, A.R., Baum, C.W.: A Reliability Output Viterbi Algorithm with Appliations to Hybrid ARQ, IEEE Transactions on Information) berechnet parallel zum Viterbi Algorithmus einen Zuverlässigkeitswert, mit welchem die Fehlerwahrscheinlichkeit für das Gesamtcodewort abgeschätzt werden kann.

■ Der BCJR Algorithmus bzw. der SOVA (Bahl, L.R., Cocke, J., Jelinek, F., Raviv, J.: Optimal Decoding of Linear Codes for Minimum Symbol Error Rate, IEEE Transactions on Information Theory, Vol. IT-20,pp. 284-287, 1974), bzw. (Hagenauer, J., Hoeher, P.: A Viterbi Algorithm with Soft-Decision Outputs and its Applications, GLOBECOM 1989, Dallas, Texas, pp. 1680-1686, Nov. 1989) betrachten Alternativen im Codetrellis. Hierbei werden bei beiden Algorithmen die Zuverlässigkeitswerte symbolweise berechnet.

Der Erfindung liegt die Aufgabe zugrunde, ein Verfahren der eingangs genannten Art aufzuzeigen, welches eine effektive Zuverlässigkeitsquantifizierung des Ergebnisses eines Kanaldecodierers ermöglicht.

Diese Aufgabe wird gelöst durch das Verfahren mit den Merkmalen des Anspruchs 1.

Vorteilhafte Ausgestaltungen des erfindungsgemäßen Verfahrens finden sich in den Unteransprüchen.

Der grundlegende Aspekt der Erfindung ist, dass in dem oben beschriebenen Verfahren zur Berechnung von Zuverlässigkeitswerten von mindestens einem Kanaldecodierergebnis die Berechnung dieser Zuverlässigkeitswerte zumindest teilweise segmentweise erfolgt.

Das Kommunikationssystem, in welchem das erfindungsgemäße Verfahren eingesetzt wird, überträgt faltungscodierte Informationen. Zusätzlich zur Faltungscodierung können auch andere Codierungsmethoden in diesem Kommunikationssystem verwendet werden.

Vorteile des erfindungsgemäßen Verfahrens bestehen darin, dass, da die Fehler bei Verwendung von Faltungscodes wie bereits beschrieben in bestimmten Segmenten gehäuft auftreten, eine Lokalisierung und Zuverlässigkeitsquantifizierung dieser fehlerhaften Segmente aufgrund der segmentweisen Berechnung ermöglicht wird. Dies ist von besonderem Vorteil in Verbindung mit ARQ-Verfahren (ARQ: Automatic Repeat Request). Weiterhin reduziert die segmentweise Betrachtung von Codewörtern die Komplexität von Berechnungen, welche mit steigender Länge der Codewörter stark ansteigt.

In einer Weiterbildung der Erfindung weisen bei der segmentweisen Berechnung der Zuverlässigkeitswerte alle Symbole, welche in je einem des mindestens einen Segments enthalten sind, den gleichen Zuverlässigkeitswert auf. Z.B. kann ein Codewort gegliedert sein in ein großes Segment mit einem hohen Zuverlässigkeitswert und ein weiteres Segment, welches einen deutlich geringeren Zuverlässigkeitswert aufweist.

In einer Ausgestaltung der Erfindung erfolgt eine Ermittlung des mindestens einen Kanaldecodierergebnisses. Dann ergibt sich insgesamt ein Verfahren, welches mindestens ein Kanaldecodierergebnis in Form einer am wahrscheinlichsten gesendeten Codesymbolfolge ermittelt und Zuverlässigkeitswerte zumindest teilweise segmentweise von diesem mindestens einen Kanaldecodierergebnis berechnet.

Vorteilhafterweise wird zur Berechnung der Zuverlässigkeitswerte für das mindestens eine Kanaldecodierergebnis ein Ergebnis eines Viterbi-Decodier-Algorithmus eingesetzt.

In einer Weiterbildung der Erfindung werden die Zuverlässigkeitswerte als Metrikdifferenz zwischen dem mindestens einen Kanaldecodierergebnis und der besten Alternative zu diesem Kanaldecodierergebnis ermittelt. Unter einer Metrik versteht man im allgemeinen ein Maß für die Entfernung, im allgemeinen Sprachgebrauch für den Abstand, zwischen zwei Elementen einer Menge. Für die konkrete Berechnung dieser Entfernung können verschiedene Metriken herangezogen werden. Das Kanaldecodierergebnis liegt in Form einer am wahrscheinlichsten gesendeten Codesymbolfolge vor, zeigt also die optimale Lösung an. Ist der "Abstand" zwischen dieser optimalen Lösung und der besten Alternative, also der zweitbesten Lösung, groß, so kann mit großer Wahrscheinlichkeit davon ausgegangen werden, dass die optimale Lösung dem richtigen Ergebnis, d.h. der tatsächlich gesendeten Codesymbolfolge entspricht.

Vorteilhafterweise werden zur Berechnung der Zuverlässigkeitswerte Zwischenergebnisse der Ermittlung des mindestens einen Kanaldecodierergebnisses verwendet. Dies impliziert, dass, sofern die Ermittlung des Kanaldecodierergebnisses und das Verfahren zur Berechnung von Zuverlässigkeitswerten dieses Kanaldecodierergebnisses zeitlich nacheinander ablaufen, Zwischenergebnisse des ersten Ermittlungsverfahrens gespeichert werden müssen. Bei gleichzeitigem Ablauf ist es denkbar, dass die Zwischenergebnisse direkt in die Berechnung der Zuverlässigkeitswerte eingesetzt werden. Die verwendeten Zwischenergebnisse können jegliche Größen sein, die bei der Ermittlung des Kanaldecodierergebnisses durch Rechnung oder ähnliche Vorgänge ermittelt werden.

In einer Ausgestaltung der Erfindung umfasst das Ergebnis des erfindungsgemäßen Verfahrens das mindestens eine Kanaldecodierergebnis und die Zuverlässigkeitswerte.

Einzelheiten und Details der Erfindung werden anhand eines Ausführungsbeispiels im folgenden erläutert. Dabei zeigt

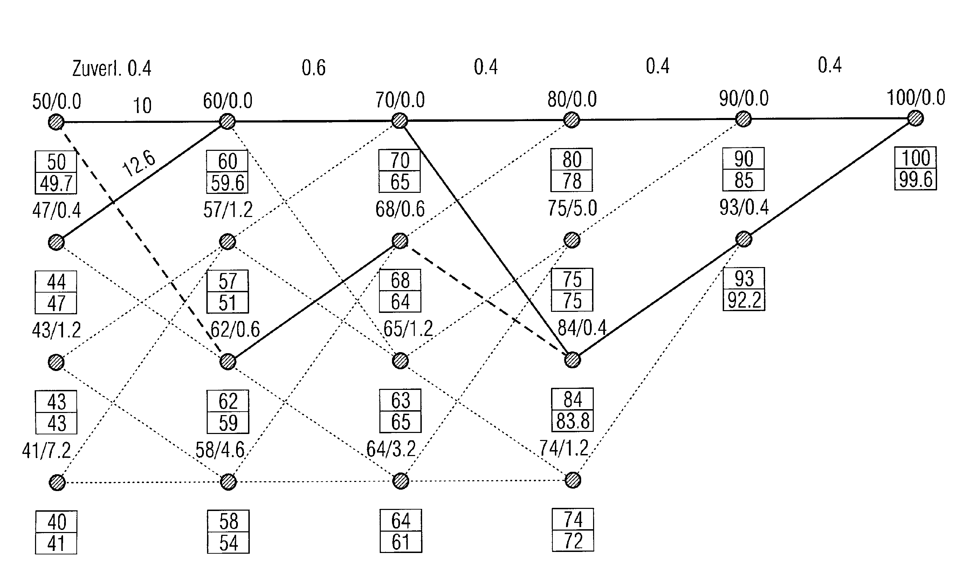

Figur 1 einen Teil eines Trellis-Diagramms.

Der Zuverlässigkeitswert $\delta_t$, welcher sich auf die Tiefe t des Trellisses bezieht, ist definiert als

$$\delta_t = \min(\Lambda(\vec{v}^{opt}_t) - \Lambda(\widetilde{\vec{v}}_t)) \ .$$

Hierbei ist die Metrik $\Lambda$ eines Codewortes, welches durch den Pfad $\vec{v}$ mit den Komponenten $\vec{v}_1$ bis $\vec{v}_n$ durch das Trellis repräsentiert wird, folgendermaßen definiert:

$$\Lambda(\vec{v}) = \lambda(\vec{v}_1) + .... + \lambda(\vec{v}_n).$$

Die Komponenten $\vec{v}_1$ bis $\vec{v}_n$ entsprechen den einzelnen Symbolen, d.h., sie stellen Übergänge im Trellis zwischen Knoten benachbarter Tiefe dar.

n steht für die Gesamttiefe des Trellisses.

Die Metrik $\lambda$ einer Komponente $\vec{v}_t$ des Pfades $\vec{v}$ ist folgendermaßen definiert:

$\lambda(\vec{v}_t) = \ln P(\vec{r}_t|\vec{v}_t)$, wobei $P(\vec{r}_t|\vec{v}_t)$ die Wahrscheinlichkeit dafür darstellt, dass das Symbol $\vec{v}_t$ gesendet wurde, wenn das empfangene Symbol $\vec{r}_t$ ist. Die Bestimmung dieser Metrik erfolgt üblicherweise im Demodulator, welche das empfangene Signal vor dem Decoder bearbeitet.

Zur Bestimmung der Zuverlässigkeitswerte $\delta_t$ werden die Komponenten des optimalen Pfades $\vec{v}^{opt}_t$ und des zweitbeste Pfades $\widetilde{v}_t$ durch das Trellis verwendet. Der optimale Pfad ist das Ergebnis der Kanaldecodierung mittels eines Viterbi-Algorithmus. Er entspricht dem am wahrscheinlichsten gesendeten Codewort. Zur Ermittlung des optimalen Pfades durch das Trellis wird die Metrik $\Lambda$ unter der Nebenbedingung maximiert, dass der ermittelte Pfad einem gültigen Codewort entspricht.

Die den gültigen Codewörtern entsprechenden Pfade sind in Figur 1 durch gepunktete Linien gekennzeichnet. Figur zeigt jedoch nicht ein vollständiges Trellis, sonder nur das "Ende" eines Trellisses. Der Knoten in der ersten Spalte von rechts entspricht also dem Endknoten, während der Anfangsknoten nicht dargestellt ist.

Es werden nun folgende Verfahrensschritte durchgeführt:

(1) Dem Anfangsknoten $\sigma_0$ bei $t$=0 wird die Knotenmetrik $\Lambda(\sigma_0)$=0 zugewiesen.

(2) Nun werden die Knoten $\sigma_t$ der anderen Tiefen $t\neq0$ betrachtet. Dabei werden zuerst die Knoten der Tiefe $t$=1, dann diejenigen der Tiefe $t$=2 bearbeitet, usw. Die Betrachtung der Knoten erfolgt also in Abbildung 1 von links nach rechts. Für jeden Knoten $\sigma_t$ werden die Zweigmetriken für alle Zweige $\vec{v}_t$, welche in dem jeweiligen Knoten enden, mittels der Beziehung

$$\Lambda(\vec{v}_t)=\Lambda(\hat{\sigma}_{t\text{-}1})+\lambda(\vec{v}_t)$$

bestimmt. Hierbei ist $\Lambda(\hat{\sigma}_{t\text{-}1})$ die Knotenmetrik desjenigen Knotens $\sigma_{t\text{-}1}$, aus welchem der Zweig stammt. Die ermittelten Zweigmetriken werden in Listen gespeichert.

Weiterhin wird dem Knoten $\sigma_t$, die Knotenmetrik $\Lambda(\sigma_t)=\Lambda(\vec{v}'_t)$ zugewiesen, wobei $\vec{v}'_t$ denjenigen Zweig bezeichnet, welcher die größte Zweigmetrik im Vergleich zu den anderen Zweigen, welche im gleichen Knoten $\sigma_t$ enden, aufweist.

In Figur 1 stellt die linke der beiden Zahlen, welche über einem jeden Knoten stehen, die Knotenmetrik dar. Die Liste unterhalb jedes Knotens enthält die Werte für die Zweigmetriken, deren Ermittlung oben beschrieben wurde. Beispielhaft soll nun der zweite Knoten von links in der obersten Reihe betrachtet werden. Seine Knotenmetrik beträgt 60. In ihn münden Zweige aus dem ersten Knoten von links in der obersten Reihe mit der Knotenmetrik 50 (erster Zweig) und aus dem ersten Knoten von links in der zweitobersten Reihe (zweiter Zweig) mit der Knotenmetrik 47. Die Metriken $\lambda$ der beiden Übergänge stehen oberhalb der Verbindungslinien zwischen den Knoten. Für den ersten Zweig ergibt sich eine Knotenmetrik für den betrachteten Knoten von 60, die sich zusammensetzt aus einer Knotenmetrik des Ausgangsknotens von 50 und der Metrik des Übergangs von 10. Dieser Wert wird in der Liste, welche unterhalb des betrachteten Knotens abgebildet ist, gespeichert. Für den zweiten Zweig ergibt sich eine Knotenmetrik für den betrachteten Knoten von 59.6, die sich zusammensetzt aus einer Knotenmetrik des Ausgangsknotens von 47 und der Metrik des Übergangs von 12.6. Auch dieser Wert wird in der Liste gespeichert. Dem betrachteten Knoten wird nun der größte der Listenwerte, im gegebenen Fall der Wert 60, zugeordnet.

Dieses Vorgehen wird auf jeden der Knoten des Trellisses angewandt, so dass sich schließlich die in Figur 1 gezeigte Wertekonfiguration ergibt.

Der Survivor des Verfahrens, also der optimale Pfad durch das Trellis wird dadurch bestimmt, dass beginnend vom Endknoten aus über die anderen (in Rückwärtsrichtung folgenden) Knoten jeweils derjenige Zweig als Pfadbestandteil gewählt wird, welcher die größte Zweigmetrik aller in einen Knoten mündenden Zweige aufweist. Dieser optimale Pfad ist der erste Ergebnis der erfindungsgemäßen Verfahrens. Die Kenntnis des optimalen Pfades wird in den folgenden Schritten eingesetzt, um die Zuverlässigkeitswerte von Segmenten zu ermitteln.

In Figur 1 entspricht der optimale Pfad dem Codewort, welches ausschließlich aus Nullen besteht (horizontale durchgezogene Linie in der obersten Reihe).

(3) Dem Endknoten wird der Knotenzuverlässigkeitswert 0 zugewiesen. Die Knotenzuverlässigkeitswerte sind in Figur 1 als die rechten der beiden Zahlen oberhalb des Knotens zu sehen.

(4) Für jeden Knoten wird die Differenz aus der Knotenmetrik und den Werten der Liste des jeweiligen Knotens gebildet. Dabei werden die Knoten in Rückwärtsrichtung, d.h. von rechts nach links in Figur 1, bearbeitet. Der Knotenzuverlässigkeitswert eines Knotens der Tiefe t-1 ergibt sich aus dem Knotenzuverlässigkeitswert des Knotens mit der Tiefe t, aus welchem ein im betrachteten Knoten mündender Zweig stammt (Ursprungsknoten), und der berechneten Differenz aus der Knotenmetrik des Ursprungsknotens und dem Listenelement des Ursprungsknotens, welches der Verbindung zwischen dem betrachteten Knoten und dem Ursprungsknoten zugeordnet ist. Falls sich im betrachteten Knoten mehrere Pfade schneiden, wird der geringste Wert für die Knotenzuverlässigkeit gewählt.

Beispielhaft wird nun der erste Knoten von rechts in der zweiten Reihe von oben mit der Knotenmetrik 93 betrachtet. Der dazugehörige Ursprungsknoten ist der erste Knoten von rechts in der ersten Reihe von oben mit der Knotenmetrik 100. Die Differenz aus der Knotenmetrik des Ursprungsknotens (Wert 100) und dem Listenelement, welches der Verbindung zwischen dem betrachteten Knoten und dem Ursprungsknoten zuzuordnen ist (Wert 99.6) beträgt 0.4. Diese Differenz wird zum Wert der Knotenzuverlässigkeit des Ursprungsknotens addiert, um einen Wert für die Knotenzuverlässigkeit des betrachteten Knotens von 0.4 zu erhalten. Betrachtet man nun den zweiten Knoten von rechts in der ersten Reihe von oben mit der Knotenmetrik von 90, für den der gleiche Knoten wie im obigen Beispiel der Ursprungsknoten ist, so ergibt sich folgendes: die Differenz aus der Knotenmetrik des Ursprungsknotens (Wert 100) und dem Listenelement, welches der Verbindung zwischen dem betrachteten Knoten und dem Ursprungsknoten zuzuordnen ist (Wert 100) beträgt 0. Diese Differenz wird zum Wert der Knotenzuverlässigkeit des Ursprungsknotens addiert, um einen Wert für die Knotenzuverlässigkeit des betrachteten Knotens von 0 zu erhalten. Es ist ersichtlich, dass für jeden Knoten des optimalen Pfades ein Wert von 0 für die Knotenzuverlässigkeit berechnet wird.

(5) Der Zuverlässigkeitswert $\delta_t$ für die Tiefe t des Trellisses ist der kleinste Knotenzuverlässigkeitswert ungleich 0, welcher bei den Knoten der Tiefe t oder der Tiefe t-1 auftritt. Dies entspricht der Bildung der Metrikdifferenz zwischen dem Kanaldecodierergebnis und der besten Alternative zu diesem Kanaldecodierergebnis. Das Decodierergebnis, welches das am wahrscheinlichsten gesendete Codewort beinhaltet, stimmt in einem bestimmten Segment mit einer umso höheren Wahrscheinlichkeit mit dem tatsächlich gesendeten Codewort überein, je größer der Zuverlässigkeitswert für das betrachtete Segment ist. Denn ist z.B. die Differenz zwischen dem höchsten und dem zweithöchsten Wert der Knotenmetrik eines Knotens nur gering, so ist die Entscheidung zugunsten eines Pfades und entsprechend gegen einen anderen Pfad nur knapp, mit geringer Signifikanz gefallen. Diese knappe Entscheidung spiegelt sich in einem geringen Wert für die Zuverlässigkeit am betrachteten Knoten wieder.

In Figur 1 sind die Zuverlässigkeitswerte Zuverl. $\delta_t$ in der obersten Reihe dargestellt. Die letzten drei Übergänge des Trellisses bilden ein Segment, gekennzeichnet durch einen einheitlichen Wert der Zuverlässigkeiten von 0.4.

Das beschriebene Verfahren läuft also zuerst in Vorwärtsrichtung ab (von links nach rechts in Figur 1) zur Bestimmung des optimalen Pfades des Trellisses, und danach in Rückwärtsrichtung (von rechts nach links in Figur 1) zur Bestimmung der Zuverlässigkeitswerte für die Segmente des zuvor ermittelten Codewortes.

Die Pfade, welche die Zuverlässigkeitswerte des besten Pfades beeinflussen, sind in Figur 1 durch durchgezogene oder gestrichelte Linien gekennzeichnet. Somit sind an dieser Darstellung alternative Codewörter ablesbar, die nicht mit dem optimalen Pfad durch das Trellis übereinstimmen.

Um das gesamte Codewort in zuverlässige und nicht zuverlässige Segmente einzuteilen, können die Zuverlässigkeitswerte Zuverl. $\delta_t$ mit mindestens einem Schwellenwert verglichen werden. Fallen Zuverlässigkeitswerte Zuverl. $\delta_t$ unter einen Schwellenwert, bewirkt dies, dass das betroffene Segment unzuverlässig ist. Es können auch für verschiedene Segmente verschiedene Schwellenwerte eingesetzt werden.

Das erfindungsgemäße Verfahren kann Vorteilhafterweise in Kombination mit einem ARQ-Verfahren (ARQ: Automatic Repeat Request) eingesetzt werden. Hierbei nutzt der Empfänger die Zuverlässigkeitsinformation des Verfahrens, um den Sender mittels eines Rückkanals über geschätzte Übertragungsfehler zu informieren. Der Sender versucht daraufhin, durch nachsenden geeigneter Redundanz für die betroffenen Segmente das Decodierergebnis zu verbessern. Beim Einsatz eines ARQ-Verfahren ist die Lokalisierung der Fehler, welche das erfindungsgemäße Verfahren bereitstellt, von besonderem Vorteil.

Weiterhin ist die Anwendung des erfindungsgemäßen Verfahrens auf verkettete Codes vorteilhaft. So kann bei der Decodierung zweier seriell verketteter Codes die Zuverlässigkeitsinformation des inneren Codes zur Decodierung der äußeren Codes mit herangezogen werden, um das Decodierergebnis des Gesamtcodes zu verbessern.

Auch im Bereich der Verdeckung von Fehlern (Error Concealment) kann der erfindungsgemäße Verfahren vorteilhaft eingesetzt werden. Bei der Wiedergabe von Audio- / Video-Signalen werden fehlerhafte Abschnitte bzw. Segmente häufig durch Austastung bzw. Interpolationstechniken verdeckt. Das erfindungsgemäße Verfahren ist geeignet, solche fehlerhaften Abschnitte aufzuspüren. Dies gilt auch für Faltungscodes mit UEP (Unequal Error Protection), bei welchen einzelne Bereiche ja nach Priorität unterschiedlich stark geschützt werden.

**Patentansprüche**

1. Verfahren zur Berechnung von Zuverlässigkeitswerten (Zuverl.) von mindestens einem Kanaldecodierergebnis in Form einer am wahrscheinlichsten gesendeten Codesymbolfolge bei der empfängerseitigen Decodierung in einem digitalen Kommunikationssystem, in welchem faltungscodierte Informationen übertragen werden,
**dadurch gekennzeichnet,**
**dass** die Berechnung der Zuverlässigkeitswerte (Zuverl.) zumindest teilweise segmentweise erfolgt.

2. Verfahren nach Anspruch 1, **dadurch gekennzeichnet, dass** bei der segmentweisen Berechnung der Zuverlässigkeitswerte (Zuverl.) alle Symbole, welche in je einem des mindestens einen Segments enthalten sind, den gleichen Zuverlässigkeitswert (Zuverl.) aufweisen.

3. Verfahren nach einem der Ansprüche 1 oder 2, **dadurch gekennzeichnet, dass** eine Ermittlung des mindestens einen Kanaldecodierergebnisses erfolgt.

4. Verfahren nach einem der Ansprüche 1 bis 3, **dadurch gekennzeichnet, dass** zur Berechnung der Zuverlässigkeitswerte (Zuverl.) für das mindestens eine Kanaldecodierergebnis ein Ergebnis eines Viterbi-Decodier-Algorithmus eingesetzt wird.

5. Verfahren nach einem der Ansprüche 1 bis 4, **dadurch gekennzeichnet, dass** die Zuverlässigkeitswerte (Zuverl.) als Metrikdifferenz zwischen dem mindestens einen Kanaldecodierergebnis und der besten Alternative zu diesem Kanaldecodierergebnis ermittelt werden.

6. Verfahren nach einem der Ansprüche 1 bis 5, **dadurch gekennzeichnet, dass** zur Berechnung der Zuverlässigkeitswerte (Zuverl.) Zwischenergebnisse der Ermittlung des mindestens einen Kanaldecodierergebnisses verwendet werden.

7. Verfahren nach einem der Ansprüche 1 bis 6, **dadurch gekennzeichnet, dass** das Ergebnis des Verfahrens das mindestens eine Kanaldecodierergebnis und die Zuverlässigkeitswerte (Zuverl.) umfasst.

8. Verfahren nach einem der Ansprüche 1 bis 7, **dadurch gekennzeichnet, dass** es folgende Verfahrensschritte umfasst:

   - Berechnen von Zweigmetriken für Zweige eines Codetrellis unter Verwendung von Metriken für einzelne Symbole,
   - Speicherung der Zweigmetriken in Listen,
   - Berechnung von Knotenmetriken für Knoten des Codetrellis,
   - Bestimmung des optimalen Pfades durch das Codetrellis,
   - Berechnung von Differenzen zwischen Knotenmetriken und in Listen gespeicherten Zweigmetriken,
   - Bestimmung von Zuverlässigkeitswerten (Zuverl.) für Segmente des optimalen Pfades.

9. Verfahren nach einem der Ansprüche 1 bis 8, **dadurch gekennzeichnet, dass** die Zuverlässigkeitswerte (Zuverl.) mit mindestens einem Schwellenwert verglichen werden.

10. Verfahren nach einem der Ansprüche 1 bis 9, **dadurch gekennzeichnet, dass** es in Verbindung mit einem ARQ-Verfahren eingesetzt wird.

11. Verfahren nach einem der Ansprüche 1 bis 10, **dadurch gekennzeichnet, dass** es in Verbindung mit verketteten Codes eingesetzt wird.

12. Verfahren nach einem der Ansprüche 1 bis 11, **dadurch gekennzeichnet, dass** es in Verbindung mit einem Error-Concealment-Verfahren eingesetzt wird.

Zuverl. 0.4          0.6          0.4          0.4          0.4

50/0.0  10  60/0.0    70/0.0    80/0.0    90/0.0    100/0.0

| 50 | | 60 | | 70 | | 80 | | 90 | | 100 |
| 49.7 | | 59.6 | | 65 | | 78 | | 85 | | 99.6 |

12.6  47/0.4    57/1.2    68/0.6    75/5.0    93/0.4

| 44 | | 57 | | 68 | | 75 | | 93 |
| 47 | | 51 | | 64 | | 75 | | 92.2 |

43/1.2    62/0.6    65/1.2    84/0.4

| 43 | | 62 | | 63 | | 84 |
| 43 | | 59 | | 65 | | 83.8 |

41/7.2    58/4.6    64/3.2    74/1.2

| 40 | | 58 | | 64 | | 74 |
| 41 | | 54 | | 61 | | 72 |

EP 1 376 881 A1

**Europäisches Patentamt**

# EUROPÄISCHER RECHERCHENBERICHT

Nummer der Anmeldung

EP 02 01 4456

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,A | RAGHAVAN A R ET AL: "A RELIABILITY OUTPUT VITERBI ALGORITHM WITH APPLICATIONS TO HYBRID ARQ" IEEE TRANSACTIONS ON INFORMATION THEORY, IEEE INC. NEW YORK, US, Bd. 44, Nr. 3, Mai 1998 (1998-05), Seiten 1214-1216, XP001031902 ISSN: 0018-9448 * Seite 1214 - Seite 1216 * --- | 1 | H03M13/41 H03M13/45 H04L1/00 H04L25/03 |
| D,A | BAHL L R ET AL: "OPTIMAL DECODING OF LINEAR CODES FOR MINIMIZING SYMBOL ERROR RATE" IEEE TRANSACTIONS ON INFORMATION THEORY, IEEE INC. NEW YORK, US, Bd. IT-20, Nr. 2, 1. März 1974 (1974-03-01), Seiten 284-287, XP000647243 ISSN: 0018-9448 * Seite 284 - Seite 287 * --- | 1 | |
| D,A | HAGENAUER J ET AL: "A VITERBI ALGORITHM WITH SOFT-DECISION OUTPUTS AND ITS APPLICATIONS" COMMUNICATIONS TECHNOLOGY FOR THE 1990'S AND BEYOND. DALLAS, NOV. 27 - 30, 1989, PROCEEDINGS OF THE GLOBAL TELECOMMUNICATIONS CONFERENCE AND EXHIBITION(GLOBECOM), NEW YORK, IEEE, US, Bd. 3, 27. November 1989 (1989-11-27), Seiten 1680-1686, XP000091258 * Seite 1680 - Seite 1686 * --- | 1 | **RECHERCHIERTE SACHGEBIETE (Int.Cl.7)** H03M H04L |
| A | H. DAWID ET AL.: "Viterbi Decoders: High Performance Algorithms and Architectures" 1999 , MARCEL DEKKER INC. , NEW YORK XP002225706 * Seite 417 - Seite 459 * ----- | 1 | |

Der vorliegende Recherchenbericht wurde für alle Patentansprüche erstellt

| Recherchenort | Abschlußdatum der Recherche | Prüfer |
|---|---|---|
| DEN HAAG | 19. Dezember 2002 | Van Staveren, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)